# EUROPEAN PATENT SPECIFICATION

(11) **EP 1 640 474 B1**
(45) Date of publication and mention of the grant of the patent: **28.08.2013**
(21) Application number: 04745448.3
(22) Date of filing: 31.05.2004
(51) Int. Cl.: C23C 14/34, C23C 16/50, C23F 4/00, H01L 21/31

(54) **THIN FILM FORMING DEVICE**
VORRICHTUNG ZUR AUSBILDUNG VON DÜNNEM FILM
DISPOSITIF DE FORMATION DE FILM MINCE

(30) Priority: 02.06.2003 WO PCT/JP03/06951
(43) Date of publication of application: 29.03.2006
(73) Proprietor: Shincron Co., Ltd., Kanagawa 220-8680 (JP)
(72) Inventor: SONG, Yizhou, Saitama 332-0011 (JP); SAKURAI, Takeshi, Yokohama-shi Kanagawa 2230052 (JP); MURATA, Takanori, Yokohama-shi Kanagawa 2300011 (JP)
(74) Representative: Grünecker, Kinkeldey, Stockmair & Schwanhäusser
(86) International application number: PCT/JP2004/007483
(87) International publication number: WO 2004/108980

(56) References cited:
- JP-A- 8 031 358
- JP-A- 9 245 997
- JP-A- 11 026 191
- JP-A- 11 209 875
- JP-A- 11 219 937
- JP-A- 2000 124 137
- JP-A- 2001 234 338
- JP-A- 2001 353 440
- JP-A- 2002 316 293
- US-A1- 2001 003 271
- US-A1- 2002 016 026
- US-A1- 2002 123 200

## Description

### TECHNICAL FIELD

The present invention relates to a thin film deposition apparatus and a thin film deposition method for forming thin films for use as optical thin films and for use in optical devices, optoelectronic devices, semiconductor devices, and the like. More particularly, the invention relates to a thin film deposition apparatus in which the density of active species, which undergo a chemical reaction with a thin film, is increased through improvement of plasma generation means and a vacuum container, as well as to a thin film deposition method using the thin film deposition apparatus.

### BACKGROUND ART

Conventionally, plasma processing, such as deposition of a thin film on a substrate, modification of the surface of a deposited thin film, or etching, has been performed by use of a reactive gas in plasma state in a vacuum container. For example, in a known technique for forming a thin film of a metal compound (disclosed in, for example, Japanese Patent Application Laid-Open (*kokai*) No. 2001-234338), a thin film of an incomplete reaction product of metal is deposited on a substrate by use of a sputtering technique, and the thin film of the incomplete reaction product is brought into contact with a reactive gas in plasma state, thereby forming a thin film of a metal compound.

The known technique uses plasma generating means in order to excite a reactive gas into plasma state in a vacuum container of a thin film deposition apparatus. The gas that is excited into plasma state by the plasma generating means contains active species such as ions, radicals, and the like. Electrons and ions contained in the plasma gas may damage a thin film, but in many cases radicals of a reactive gas, which are electrically neutral, contribute to deposition of a thin film. Thus, the conventional technique uses a grid in order to prevent electrons and ions from heading toward a thin film on a substrate so as to selectively bring radicals into contact with the thin film. Use of a grid increases the relative density of radicals-which contribute to deposition of a thin film-in a plasma gas, thereby enhancing the efficiency of plasma processing.

However, use of a grid in order to increase the relative density of radicals involves the following problems: the structure of a thin film deposition apparatus becomes complex; and the dimensions, shape, and arrangement of a grid impose limitation on the range of distribution of radicals within the vacuum container. Involvement of the problems hinders performance of plasma processing over a wide range and thus impairs the efficiency of plasma processing, thus hindering enhancement of thin-film production efficiency. When the size of a grid is increased in order to increase the range of distribution of radicals, costs increase.

Conventionally, a parallel-plate-type apparatus, an ECR-type apparatus, an inductively-coupled-type apparatus, and the like are known as plasma generating means for generating a plasma. Inductively-coupled-type apparatus are known to be classified into a cylindrical type and a plate type.

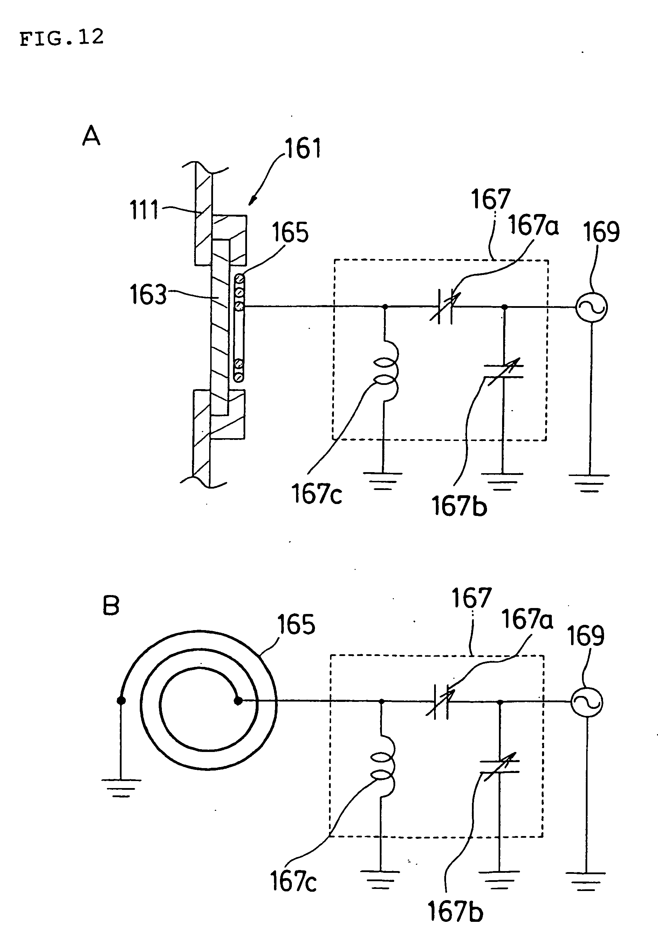

FIG. 12 is a view for explaining a conventional plate-type plasma generator 161. FIG. 12A is a sectional view showing a portion of a thin film deposition apparatus. As shown in FIG. 12A, in conventional plate-type plasma generating means, a dielectric plate 163-which is formed of a dielectric such as quartz-partially constitutes a vacuum container 111; and an antenna 165 is disposed along the outer wall of the dielectric plate 163-the outer wall faces the atmosphere.

The shape of the antenna 165 is shown in FIG. 12B. The antenna 165 spirals in a plane. In the conventional plate-type plasma generator 161, an RF power supply 169 applies power having a frequency of 100 kHz to 50 MHz to the antenna 165 via a matching box 167 having a matching circuit, thereby generating a plasma within the vacuum container 111.

RF power is applied to the antenna 165 via a matching circuit adapted to perform impedance matching-the matching circuit is represented by the matching box 167 shown in FIG. 12. As shown in FIG. 12, the matching circuit is connected to the antenna 165 and to the RF power supply 169 while intervening therebetween, and includes variable capacitors 167a and 167b and a matching coil 167c.

In the conventional plasma generating means, when plasma processing is to be performed over a wide range within the vacuum container, the size of the antenna 165 is increased. However, this involves an increase in power loss in the antenna 165 and in the matching coil 167c and causes difficulty in establishing impedance match. Also, when plasma processing is performed over a wide range, the density of a plasma fails to become uniform over the range.

US 2002/016026 A1 relates to an apparatus for manufacturing active matrix device including a processing chamber, a vacuum system, a gas supply system, a power source, electrodes and an oxide film.

In view of the above problems, an object of the present invention is to provide a thin film deposition apparatus and a thin film deposition method in which plasma processing can be performed efficiently over a wide range.

### DISCLOSURE OF THE INVENTION

A thin film deposition apparatus according to the present invention comprises a vacuum container, gas introduction means for introducing a reactive gas into the vacuum container, and plasma generating means for generating a plasma of the reactive gas within the vacuum container. The thin film deposition apparatus is characterized in that the plasma generating means comprises a dielectric wall provided on an outer wall of the vacuum container, a first antenna having a spiral shape, a second antenna having a spiral shape, and a conductor wire for connecting said first and second antennas to an RF power supply, comprising an antenna fixing means for fixing said first and second antennas outside of the vacuum container in a position corresponding to said dielectric wall, wherein the first and second antennas are connected in parallel in relation to the RF power supply, and arranged adjacent to each other in a direction perpendicular to a normal to a plane on which the first and the second antennas are spiraled.

Since the thin film deposition apparatus of the present invention includes the first antenna and the second antenna, the distribution of a plasma can be readily adjusted by independently adjusting parameters, such as thickness, shape, size, and diameter, of the first and second antennas. Even when a matching circuit is connected to the first and second antennas, parallel connection of the first and second antennas facilitates impedance matching in the matching circuit and reduces power loss in the matching circuit to thereby allow effective use of power for generation of a plasma. Furthermore, since the first and the second antennas are arranged adjacent to each other in the direction perpendicular to the normal to the plane on which the first and second antennas are spiraled, plasma processing can be performed over a wide range.

Then, preferably, a position adjusting means for adjusting the distance between said first antenna and said second antenna is provided at a portion which connects said first antenna and said second antenna together and which is connected to said conductor wire. Thus, the distribution of a plasma can be readily adjusted by adjusting the distance between the first antenna and the second antenna.

Preferably, substrate transport means for transporting substrates is provided in the vacuum container; the transport means transports substrates such that the substrates face a plane in which the first antenna and the second antenna form respective spirals; and the first antenna and the second antenna are fixed while being arranged adjacent to each other in a direction intersecting a direction in which the substrates are transported by the substrate transport means.
Through employment of the above substrate transport means structure, the density distribution of a plasma can be readily adjusted in a direction perpendicular to the direction in which substrates are transported. Therefore, plasma processing can be performed over a wide range in a direction perpendicular to the direction in which substrates are transported, so that a large quantity of thin film can undergo plasma processing in a single operation.

Preferably, each of the first antenna and the second antenna comprises a body member assuming the form of a round tube and formed of a first material, and a coating layer covering a surface of the body member and formed of a second material having electric resistance lower than that of the first material.
Through employment of the above antenna structure, a material that is inexpensive and easily worked can be used as the first material in order to form the body members of the first and second antennas; and a material having low electric resistance can be used as the second material in order to form the coating layer, in which current concentrates. Thus, the high-frequency impedance of the antennas can be lowered, so that a thin film can be efficiently formed.

The gas introduction means introduces a reactive gas and an inert gas into a region where plasma is generated by the plasma generating means. Employment of the above configuration could introduce a reactive gas and an inert gas into a region where a plasma is generated.

A thin film deposition apparatus, according to the present invention comprises the features of claim 1.

Since an insulator covers the inner wall surface of the vacuum container, there can be suppressed vanishment of active species, such as radicals or excited radicals, contained in a plasma which is generated by the plasma generating means -such vanishment would otherwise result from reaction of active species with the vacuum container wall.
Since the gas introduction means, the gas introduction means introduce a reactive gas and an inert gas into a region where plasma is generated.

And then, preferably, said inert gas is selected from a group consisting of argon gas, helium gas, neon gas, krypton gas, and xenon gas.

Since an insulator covers the inner wall surface of the vacuum container, there can be suppressed vanishment of active species, such as radicals or excited radicals, contained in a plasma-such vanishment would otherwise result from reaction of active species with the vacuum container.

Since an insulator covers the plasma converging wall, there can be suppressed vanishment of active species, such as radicals or excited radicals, contained in a plasma generated by the plasma generating means-such vanishment would otherwise result from reaction of active species with the surface of the plasma converging wall. Since the plasma converging wall is provided, the distribution of a plasma can be controlled by means of the plasma converging wall.

Further advantageous embodiments are defined by claims 4 and 5.

### BRIEF DESCRIPTION OF DRAWINGS

[FIG. 1] FIG. 1 is a partially sectional, explanatory top view for explaining a thin film deposition apparatus of the present invention.
[FIG. 2] FIG. 2 is a partially sectional, explanatory side view for explaining the thin film deposition apparatus of the present invention.
[FIG. 3] FIG. 3 is an explanatory view for explaining plasma generating means.
[FIG. 4] FIG. 4 is a sectional view of an antenna.
[FIG. 5] FIG. 5 is a graph of example test results, showing the results of measurement of proportion of oxygen atoms and oxygen ions contained in a plasma.
[FIG. 6] FIG. 6 is a graph of example test results, showing the results of measurement of emission intensity of excited oxygen radicals and oxygen ions contained in a plasma.
[FIG. 7] FIG. 7 is a graph of example test results, showing the results of measurement of emission intensity of excited oxygen radicals and oxygen ions contained in a plasma.
[FIG. 8] FIG. 8 is a graph of example test results, showing the results of measurement of emission intensity of excited oxygen radicals contained in a plasma.
[FIG. 9] FIG. 9 is a graph of example test results, showing the results of measurement of flow density of oxygen radicals contained in a plasma.
[FIG. 10] FIG. 10 is a graph of example test results, showing the results of measurement of transmittance of a multilayered thin film that is formed of silicon oxide and niobium oxide by use of conventional plasma generating means.
[FIG. 11] FIG. 11 is a graph of example test results, showing the results of measurement of transmittance of a multilayered thin film that is formed of niobium oxide and silicon oxide by use of plasma generating means of the present invention.
[FIG. 12] FIG. 12 is an explanatory view for explaining conventional plate-type plasma generating means.

### BEST MODE FOR CARRYING OUT THE INVENTION

An embodiment of the present invention will next be described in detail with reference to the drawings. Members, arrangement, and the like to be described below should not be construed as limiting the invention, but may be modified in various forms without departing from the scope of the invention.

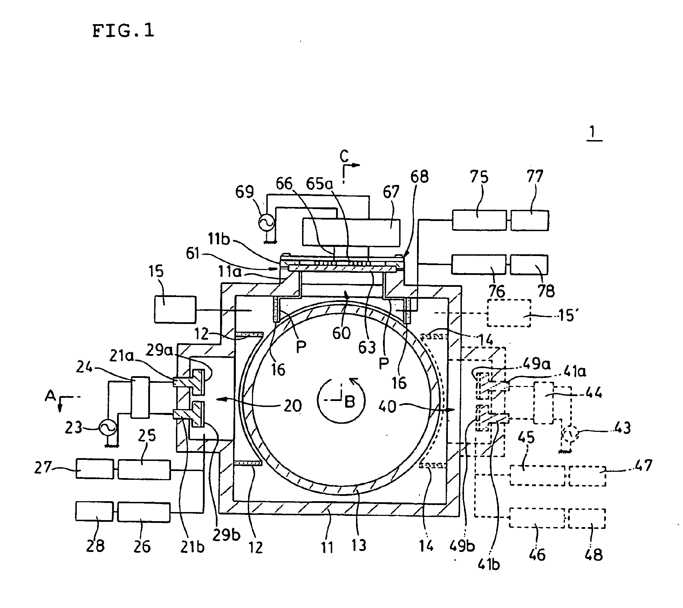

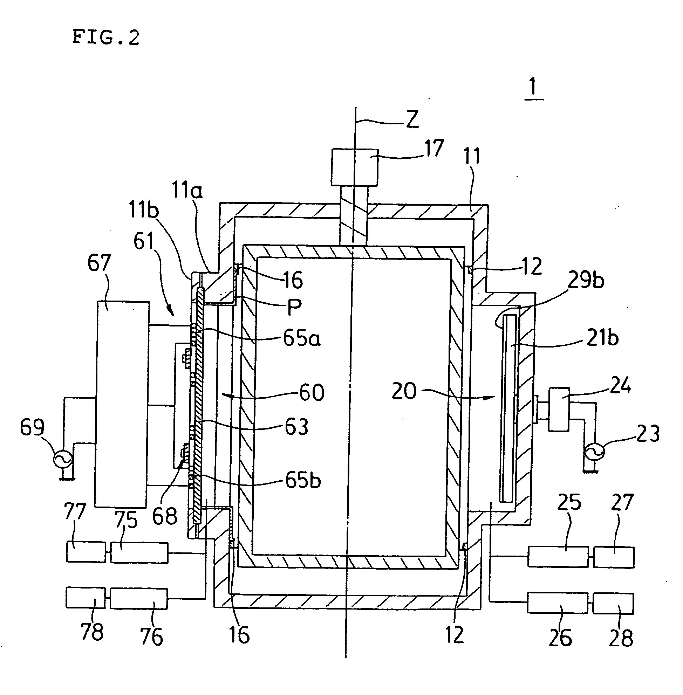

FIGS. 1 and 2 are explanatory views for explaining a sputtering apparatus 1. FIG. 1 is an explanatory top view with a partial section provided for easy understanding. FIG. 2 is a partially sectional, explanatory side view taken along line A-B-C of FIG. 1. The sputtering apparatus 1 is an example of a thin film deposition apparatus of the present invention.

The sputtering apparatus 1 of the present embodiment performs magnetron sputtering, which is a type of sputtering. However, the type of sputtering is not limited thereto. The sputtering apparatus 1 may perform another known type of sputtering, such as diode sputtering without use of magnetron discharge.

The sputtering apparatus 1 of the present embodiment repeats a cycle of depositing a thin film considerably thinner than a target thickness on a substrate by sputtering, and performing plasma processing on the thin film, thereby forming on the substrate a thin film having the target thickness. The present embodiment repeats the step of forming a thin film having an average thickness of 0.01 nm to 1.5 nm by means of sputtering and plasma processing, thereby forming a thin film having a target thickness of several nanometers to several hundreds of nanometers.

Major components of the sputtering apparatus 1 of the present embodiment include a vacuum container 11; a substrate holder 13 for holding substrates, on which a thin film is to be formed, within the vacuum container 11; a motor 17 for driving the substrate holder 13; partitions 12 and 16; magnetron sputter electrodes 21a and 21b; an intermediate frequency AC power supply 23; and a plasma generator 61 for generating a plasma. The partition 16 corresponds to a plasma converging wall of the present invention; the plasma generator 61 corresponds to plasma generating means of the present invention; and the substrate holder 13 and the motor 17 correspond to substrate transport means of the present invention.

As in the case of a known sputtering apparatus, the vacuum container 11 is a hollow stainless steel body generally assuming the shape of a rectangular parallelepiped. The vacuum container 11 is earthed. The vacuum container 11 may assume a hollow, cylindrical shape.

The substrate holder 13 is disposed within the vacuum container 11 substantially at the center. The substrate holder 13 assumes a cylindrical shape and holds a plurality of substrates (not shown) on its outer circumferential surface. The shape of the substrate holder 13 is not limited to a cylindrical shape, but may be a hollow prismatic shape or a hollow conical shape. The substrate holder 13 is electrically insulated from the vacuum container 11, being in a floating potential state. The substrate holder 13 is disposed within the vacuum container 11 such that a Z axis (see FIG. 2) of its cylindrical shape coincides with the vertical direction of the vacuum container 11. The substrate holder 13 is rotated about the Z axis by means of the motor 17 provided above the vacuum container 11 while a vacuum is maintained within the vacuum container 11.

A number of substrates (not shown) are held on the outer circumferential surface of the substrate holder 13 while being arrayed at predetermined intervals along the direction of the Z axis (along the vertical direction). In the present embodiment, a substrate is held on the substrate holder 13 such that its surface (hereinafter referred to as a "film deposition surface") on which a thin film is to be formed faces a direction perpendicular to the Z axis of the substrate holder 13.

The partitions 12 and 16 are provided on the inner wall surface of the vacuum container 11 and extend toward the substrate holder 13. In the present embodiment, the partition 12 (16) is a stainless steel member that assumes the shape of an open-ended tubular, rectangular parallelepiped. The partition 12 (16) is fixed on an inner side wall of the vacuum container 11 and extends toward the substrate holder 13. The partition 12 (16) is fixed such that one opening is located on the side toward the inner side wall of the vacuum container 11, whereas the other opening faces the substrate holder 13. An end portion of the partition 12 (16) that faces the substrate holder 13 assumes a shape corresponding to the circumferential outline of the substrate holder 13.

A film deposition process zone 20 for performing sputtering is formed in such a manner as to be surrounded by the inner wall surface of the vacuum container 11, the partition 12, and the outer circumferential surface of the substrate holder 13. A reaction process zone 60 for generating a plasma in order to perform plasma processing on thin films formed on corresponding substrates is formed in such a manner as to be surrounded by the inner wall surface of the vacuum container 11, the plasma generator 61 to be described later, the partition 16, and the outer circumferential surface of the substrate holder 13. In the present embodiment, the partitions 12 and 16 of the vacuum container 11 are shifted in position from each other by about 90 degrees about the Z axis of the substrate holder 13. Thus, the film deposition process zone 20 and the reaction process zone 60 are shifted in position from each other by about 90 degrees about the Z axis of the substrate holder 13. When the substrate holder 13 is rotated by means of the motor 17, substrates held on the outer circumferential surface of the substrate holder 13 are transported between a position where the substrates face the film deposition process zone 20, and a position where the substrates face the reaction process zone 60.

Exhaust piping is connected to a zone of the vacuum container 11 located between the film deposition process zone 20 and the reaction process zone 60. A vacuum pump 15 is connected to the exhaust piping in order to evacuate the vacuum container 11. The vacuum pump 15 and an unillustrated controller are adapted to adjust the degree of vacuum within the vacuum container 11.

The wall surface of the partition 16 that faces the reaction process zone 60 is coated with a protection layer P formed of an insulator. A portion of the inner wall surface of the vacuum container 11 that faces the reaction process zone 60 is also coated with the protection layer P formed of an insulator. As to an insulator, pyrolytic boron nitride (PBN), aluminum oxide (Al₂O₃), silicon oxide (SiO₂),or boron nitride (BN) may be used for forming a protection layer P. The protection layer P is deposited on the partition 16 or the inner wall surface of the vacuum container 11 by chemical vapor deposition, evaporation method, spraying process, etc. Pyrolytic boron nitride may be deposited on the partition 16 or the inner wall surface of the vacuum container 11 by a pyrolysis process that utilizes chemical vapor deposition.

Mass flow controllers 25 and 26 are connected to the film deposition process zone 20 via piping. The mass flow controller 25 is connected to a sputter gas container 27 that stores an inert gas. The mass flow controller 26 is connected to a reactive gas container 28 that stores a reactive gas. An inert gas and a reactive gas are introduced into the film deposition process zone 20 under control of the mass flow controllers 25 and 26, respectively. Examples of an applicable inert gas introduced into the film deposition process zone 20 include argon gas, helium gas, neon gas, krypton gas, xenon gas, and the like. Examples of an applicable reactive gas introduced into the film deposition process zone 20 include oxygen gas, nitrogen gas, fluorine gas, ozone gas, and the like.

In the film deposition process zone 20, the magnetron sputter electrodes 21a and 21b are arranged on the wall surface of the vacuum container 11 in such a manner that they face the outer circumferential surface of the substrate holder 13. The magnetron sputter electrodes 21a and 21b are fixed to the vacuum container 11, which has the ground potential, via an unillustrated insulating member. The magnetron sputter electrodes 21a and 21b are connected to the intermediate frequency AC power supply 23 via a transformer 24, so that an alternating electric field can be applied thereto. In the present embodiment, the intermediate frequency AC power supply 23 applies an alternating electric field of 1 kHz to 100 kHz. Targets 29a and 29b are held on the magnetron sputter electrodes 21a and 21b, respectively. The targets 29a and 29b assume the shape of a flat plate. The targets 29a and 29b are held in such a manner as to face a direction perpendicular to the Z axis of the substrate holder 13; i.e., to face the outer circumferential surface of the substrate holder 13.

Notably, instead of a single film deposition process zone, where sputtering is performed, a plurality of film deposition process zones may be provided. Specifically, as represented by the dashed line in FIG. 1, a film deposition process zone 40 similar to the film deposition process zone 20 can additionally be provided in the vacuum container 11. For example, the film deposition process zone 40 can be formed through provision of a partition 14 in the vacuum container 11 such that the film deposition process zone 40 and the film deposition process zone 20 are located symmetrically in relation to the substrate holder 13. As in the case of the film deposition process zone 20, magnetron sputter electrodes 41a and 41b are arranged in the film deposition process zone 40. The magnetron sputter electrodes 41a and 41b are connected to an intermediate frequency AC power supply 43 via a transformer 44, so that an alternating electric field can be applied thereto. Targets 49a and 49b are held on the magnetron sputter electrodes 41a and 41b, respectively. Mass flow controllers 45 and 46 are connected to the film deposition zone 40 via piping. The mass flow controller 45 is connected to a sputter gas container 47 that stores an inert gas. The mass flow controller 46 is connected to a reactive gas container 48 that stores a reactive gas. Exhaust piping is connected to a zone of the vacuum container 11 located between the film deposition process zone 40 and the reaction process zone 60. A vacuum pump 15' is connected to the exhaust piping in order to evacuate the vacuum container 11. The vacuum pump 15 may be used in common so as to serve as the vacuum pump 15'.

An opening is formed in a wall of the vacuum container 11 that corresponds to the reaction process zone 60. The plasma generator 61, which serves as plasma generating means, is connected to the opening. The following piping, which serves as gas introduction means of the present invention, is connected to the reaction process zone 60: piping for introducing an inert gas from an inert gas container 77 via a mass flow controller 75; and piping for introducing a reactive gas from a reactive gas container 78 via a mass flow controller 76. Examples of an applicable inert gas introduced into the film deposition process zone 60 include argon gas, helium gas, neon gas, krypton gas, xenon gas, and the like. Examples of an applicable reactive gas introduced into the film deposition process zone 60 include oxygen gas, nitrogen gas, fluorine gas, ozone gas, and the like.

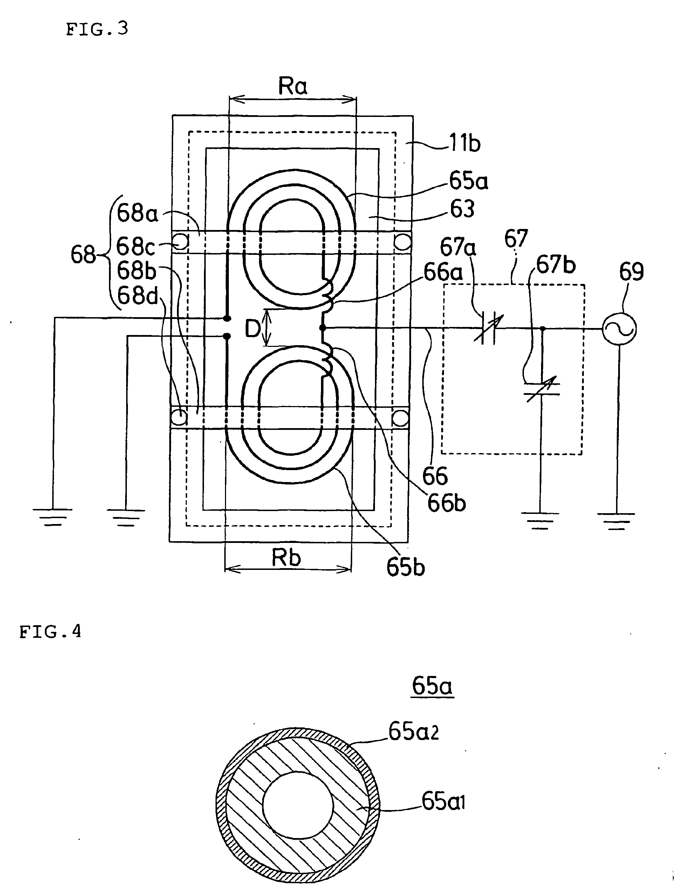

FIG. 3 is an explanatory view for explaining the plasma generator 61, showing the front view of the plasma generator 61. FIG. 3 also shows a matching box 67 and an RF power supply 69.

The plasma generator 61 includes a dielectric wall 63, which is formed into a plate-like shape from a dielectric; antennas 65a and 65b, which are spiraled on the same plane; a conductor wire 66 for connecting the antennas 65a and 65b to the RF power supply 69; and a fixture 68 for fixing the antennas 65a and 65b to the dielectric wall 63. The antenna 65a corresponds to a first antenna of the present invention; the antenna 65b corresponds to a second antenna of the present invention; and the fixture 68 corresponds to coil fixing means of the present invention.

In the present embodiment, the dielectric wall 63 is formed of quartz. In place of quartz, another ceramic material, such as Al₂O₃, may be used to form the dielectric wall 63. While being held between a rectangular frame-like cover 11b and a flange 11a formed on the vacuum container 11, the dielectric wall 63 is positioned in such a manner as to cover the opening, which is formed in a wall of the vacuum container 11 to correspond to the reaction process zone 60. The antennas 65a and 65b are fixed to the dielectric wall 63 by means of the fixture 68 at the outside of the vacuum container 11 in such a manner as to be vertically adjacent to each other and such that the plane in which the antennas 65a and 65b are spiraled faces the interior of the vacuum container 11 (see FIGS. 2 and 3). In other words, as shown in FIG. 2 and FIG. 3, the antenna 65a and the antenna 65b are fixed, keeping a predetermined distance D therebetween in a direction perpendicular to a normal to a plane on which the antenna 65a and the antenna 65b are spiraled (dielectric wall 63) .

Thus, when the motor 17 rotates the substrate holder 13 about the Z axis, substrates held on the outer circumferential surface of the substrate holder 13 are transported in such a manner as to face the plane in which the antennas 65a and 65b are spiraled. In other words, in the present embodiment, since the antennas 65a and 65b are fixed vertically adjacent to each other, the antennas 65a and 65b are fixed while being arranged adjacent to each other in a direction (in a direction parallel to the Z axis, i.e., in the vertical direction in the present embodiment) intersecting the direction in which the substrates are transported.

In the present embodiment, the fixture 68 includes fixing plates 68a and 68b and bolts 68c and 68d. The antenna 65a is held between the fixing plate 68a and the dielectric wall 63; the antenna 65b is held between the fixing plate 68b and the dielectric wall 63; and the fixing plates 68a and 68b are fixed to the cover 11b by fastening the bolts 68c and 68d, to thereby fix the antennas 65a and 65b.

The antennas 65a and 65b are connected, in parallel in relation to the RF power supply 69, to an end of the conductor wire 66, which extends between the RF power supply 69 and the antennas 65a and 65b. The antennas 65a and 65b are connected to the RF power supply 69 via the matching box 67, which accommodates a matching circuit. As shown in FIG. 3, variable capacitors 67a and 67b are provided within the matching box 67. In the present embodiment, since the antenna 65a and the antenna 65b are connected in parallel, the antenna 65b entirely or partially plays the role that the matching coil 167c plays in the conventional matching circuit (see FIG. 12). Thus, power loss in the matching box 67 is reduced, so that power supplied from the RF power supply 69 can be effectively used in the antennas 65a and 65b for generating a plasma. Also, impedance matching is facilitated.

In order to enable adjustment of a distance D between the antenna 65a and the antenna 65b, slack portions 66a and 66b are provided at a connection portion which connects the antenna 65a and the antenna 65b together and which is connected to an end of the conductor wire 66. The slack portions 66a and 66b correspond to position adjusting means of the present invention. In the sputtering apparatus 1 of the present embodiment, when the antennas 65a and 65b are to be fixed by means of the fixture 68, the vertical distance D between the antenna 65a and the antenna 65b can be adjusted by expanding or contracting the slack portions 66a and 66b. In other words, the distance D can be adjusted by changing the positions of the antennas 65a and 65b at which the antennas 65a and 65b are held between the dielectric wall 63 and the fixing plates 68a and 68b, respectively.

FIG. 4 is a sectional view of the antenna 65a. In the present embodiment, the antenna 65a includes a body member 65a₁ assuming the form of a round tube and formed of copper, and a coating layer 65a₂ covering the surface of the body member 65a₁ and formed of silver. Preferably, in order to lower the impedance of the antenna 65a, a material having low electric resistance is used to form the antenna 65a. Through utilization of a characteristic that RF current concentrates on the surface of an antenna, the body member 65a₁ is formed into a round tube from copper, which is inexpensive, easily worked, and low in electric resistance, whereas the outer surface of the body member 65a₁ is coated with silver, which is lower in electric resistance than copper, thereby forming the coating layer 65a₂. Employment of the above configuration lowers the RF-related impedance of the antennas 65a and 65b and allows efficient flow of current through the antenna 65a, thereby enhancing plasma generation efficiency. As in the case of the antenna 65a, the antenna 65b includes a body member 65b₁ formed of copper, and a coating layer 65b₂ formed of silver. Of course, the antennas 65a and 65b can be modified in terms of sectional size (thickness). In the present embodiment, a similar structure is imparted to the slack portions 66a and 66b; i.e., the slack portions 66a and 66b are formed into a round tube from copper, and their surfaces are coated with silver.

In the plasma generator 61 used in the present embodiment, after adjustment of the vertical distance D between the antenna 65a and the antenna 65b, the diameter Ra of the antenna 65a, the diameter Rb of the antenna 65b, and the like, the antennas 65a and 65b are fixed; and a reactive gas contained in the reactive gas container 78 is introduced via the mass flow controller 75 into the reaction process zone 60, which is maintained at a vacuum of about 0.1 Pa to 10 Pa. Then, voltage having a frequency of 13.56 MHz is applied to the antennas 65a and 65b from the RF power supply 69, whereby a plasma of the reactive gas can be generated with a desired distribution in the reaction process zone 60 in order to perform plasma processing on substrates arranged on the substrate holder 13.

In the present embodiment, as compared with the case of using a single large antenna, employment of two antennas 65a and 65b connected in parallel and the slack portions 66a and 66b lowers power loss in the matching circuit contained in the matching box 67 and facilitates impedance matching. Thus, plasma processing can be performed efficiently over a wide range.

Furthermore, the body members 65a₁ and 65b₁ of the antennas 65a and 65b, respectively, are formed into a round tube from copper, which is inexpensive, easily worked, and low in electric resistance, and the coating layers 65a₂ and 65b₂ are formed of silver, which is lower in electric resistance than copper. Thus, RF-related impedance of the antennas 65a and 65b can be lowered, so that plasma processing can be performed efficiently with low power loss.

In the present embodiment, through adjustment of the vertical distance D between the antenna 65a and the antenna 65b, the distribution of a plasma can be adjusted in relation to substrates arranged on the substrate holder 13. Since the diameters Ra and Rb of the antennas 65a and 65b, respectively, the thickness of the antennas 65a and 65b, and the like can be modified independently, the distribution of a plasma can also be adjusted through adjustment of, for example, the diameters Ra and Rb of the antennas 65a and 65b or the thickness of the antennas 65a and 65b. In the present embodiment, as shown in FIG. 3, the antennas 65a and 65b are each shaped like a group of semicircles of different sizes. However, the overall shape of each of the antennas 65a and 65b may be modified to a rectangular shape in order to adjust the distribution of a plasma.

Particularly, since the antenna 65a and the antenna 65b are arranged adjacent to each other in a direction intersecting the direction (in a direction parallel to the Z axis) in which substrates are transported, and the distance between the antenna 65a and the antenna 65b can be adjusted, in the case where plasma processing must be performed over a wide range in a direction intersecting the direction (in a direction parallel to the Z axis) in which substrates are transported, the density distribution of a plasma can be readily adjusted. For example, when plasma processing is performed by use of the carousel-type sputtering apparatus 1 as in the case of the present embodiment, substrates located at an upper portion of the substrate holder 13 may differ in the thickness of a thin film from those located at an intermediate portion of the substrate holder 13 depending on, for example, the arrangement of substrates on the substrate holder 13 or sputtering conditions. Even in such a case, the present embodiment has an advantage in that use of the plasma generator 61 allows adjustment of the density distribution of a plasma in accordance with difference in film thickness.

In the present embodiment, as described above, pyrolytic boron nitride covers a wall surface of the partition 16 that faces the reaction process zone 60, and a portion of the inner wall surface of the vacuum container 11 that faces the reaction process zone 60, whereby the density of radicals in the reaction process zone 60 is held high. By so doing, more radicals are brought into contact with thin films formed on respective substrates, thereby enhancing the efficiency of plasma processing. In other words, the inner wall surface of the partition 16 and the inner wall surface of the vacuum container 11 are coated with chemically stable pyrolytic boron nitride so as to suppress vanishment of radicals or excited radicals generated in the reaction process zone 60 by the plasma generator 61-such vanishment would otherwise result from reaction of radicals or excited radicals with the wall surface of the partition 16 and the inner wall surface of the vacuum container 11. The partition 16 can direct, toward the substrate holder 13, radicals generated in the reaction process zone 60.

Next will be described an example plasma processing method that uses the above-described sputtering apparatus 1. In the plasma processing method, plasma processing is performed on a thin film of incomplete silicon oxide (SiOₓ₁ (x1 < 2)) that is formed on a substrate by means of sputtering, thereby forming a thin film of silicon oxide (SiOₓ₂ (x1 < x2 ≤ 2)) whose oxidation is more advanced than incomplete silicon oxide. Incomplete silicon oxide is expressed by SiOₓ (x < 2), indicating lack of a constituent oxygen element of silicon oxide SiO₂.

First, substrates and the targets 29a and 29b are set in the sputtering apparatus 1. Specifically, substrates are held on the substrate holder 13. The targets 29a and 29b are held on the magnetron sputter electrodes 21a and 21b, respectively. Silicon (Si) is used as material for the targets 29a and 29b.

Next, the internal pressure of the vacuum container 11 is reduced to a predetermined pressure. The motor 17 is activated to thereby rotate the substrate holder 13. After pressure in the vacuum container 11 is stabilized, the pressure of the film deposition process zone 20 is adjusted to 0.1 Pa to 1.3 Pa.

Next, argon gas as an inert gas for sputtering and oxygen gas as a reactive gas are introduced into the film deposition process zone 20 from the sputter gas container 27 and the reactive gas container 28, respectively, while their flow rates are regulated by means of the mass flow controllers 25 and 26. In this manner, a sputtering atmosphere is adjusted in the film deposition process zone 20.

Next, AC voltage having a frequency of 1 kHz to 100 kHz is applied from the intermediate frequency AC power supply 23 to the magnetron sputter electrodes 21a and 21b via the transformer 24, thereby applying an alternating electric field to the targets 29a and 29b. Thus, at a certain point of time, the target 29a becomes a cathode (negative electrode), whereas the target 29b becomes an anode (positive electrode). At a next point of time when alternating current reverses in direction, the target 29b becomes a cathode (negative electrode), whereas the target 29a becomes an anode (positive electrode). In this manner, the paired targets 29a and 29b alternately become an anode and a cathode, to thereby generate a plasma, whereby a target on a cathode is sputtered.

In the process of sputtering, silicon oxide (SiOₓ (x ≤ 2)), which is nonconductive or of low conductivity, may adhere to an anode. However, when an alternating electric field causes the anode to be changed to a cathode, the adhering silicon oxide (SiOₓ (x ≤ 2)) is sputtered, so that the surface of the target becomes clean again.

The paired targets 29a and 29b alternately become an anode and a cathode repeatedly, so that a stable anode-potential state is established at all times, thereby preventing a change in plasma potential (generally equal to anode potential). Thus, a thin film of silicon or incomplete silicon oxide (SiOₓ₁ (x1 < 2)) is stably formed on the film deposition surface of each substrate.
In the film deposition process zone 20, a thin film can be formed of silicon (Si), silicon oxide (SiO₂), or incomplete silicon oxide (SiOₓ₁ (x1 < 2)) by adjusting the flow rate of oxygen gas to be introduced into the film deposition process zone 20 or by controlling the rotational speed of the substrate holder 13.

After a thin film of silicon or incomplete silicon oxide (SiOₓ₁ (x1 < 2))is formed on the film deposition surface of each substrate in the film deposition process zone 20, the substrate holder 13 is rotated so as to transport substrates from a position where the substrates face the film deposition process zone 20, to a position where the substrates face the reaction process zone 60.

Oxygen gas as a reactive gas and argon gas as an inert gas are introduced into the reaction process zone 60 from the reactive gas container 78 and the inert gas container 77, respectively. Next, voltage having a radio frequency of 13.56 MHz is applied to the antennas 65a and 65b, whereby the plasma generator 61 generates a plasma in the reaction process zone 60. The pressure of the reaction process zone 60 is maintained at 0.7 Pa to 1 Pa.

Next, when, as a result of rotation of the substrate holder 13, substrates on each of which a thin film of silicon or incomplete silicon oxide (SiOₓ₁ (x1 < 2)) has been formed are transported to a position where the substrates face the reaction process zone 60, the thin film of silicon or incomplete silicon oxide (SiOₓ₁ (x1 < 2)) formed on each substrate is oxidized by means of plasma processing in the reaction process zone 60. Specifically, by means of a plasma of oxygen gas that is generated in the reaction process zone 60 by the plasma generator 61, silicon or incomplete silicon oxide (SiOₓ₁ (x1 < 2)) is oxidized to thereby be converted to incomplete silicon oxide having a desired composition (SiOₓ₂ (x1 < x2 < 2)) or to silicon oxide.

By carrying out the above-described process, a thin film of silicon oxide having a desired composition (SiOₓ (x ≤ 2)) can be formed. By repeating the above-described process, thin films are formed in layers, whereby a thin film having a desired thickness can be formed.

Particularly, in the present embodiment, not only a reactive gas but also an inert gas is introduced into the reaction process zone 60. A shape of the reaction process zone 60 or pressure of the reaction process zone 60, conditions of discharging by the antennas 65a, 65b, and kinds of an inert gas and a reactive gas dictate an optimal percentage of the inert gas to be introduced into the reaction process zone 60. For instance, the inert gas is introduced at the flow rate of approximately 27% to the total of the flow rate of the reactive gas and that of the inert gas.

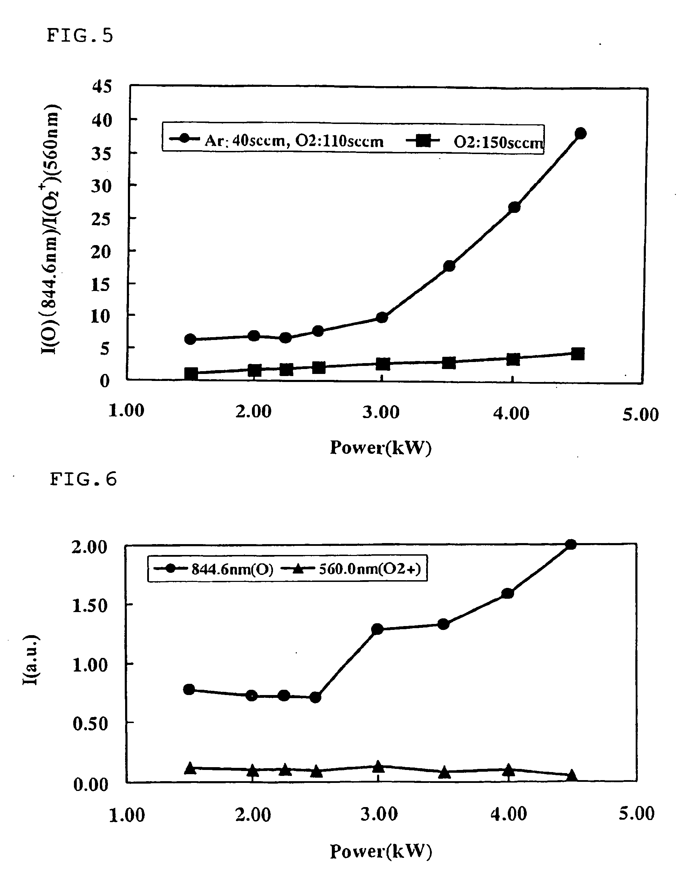

In the present embodiment, not only a reactive gas but also an inert gas is introduced into the reaction process zone 60, so that the density of radicals of the reactive gas in a plasma can be increased. This effect is shown in FIGS. 5, 6 and 7. FIG. 5, 6 and 7 illustrate test results in the case that oxygen was introduced as a reactive gas while argon gas was introduced as an inert gas.

FIG. 5 is a graph showing the proportion of oxygen atoms and oxygen ions contained in a plasma generated in the reaction process zone 60 and shows the comparative test results between the case of introduction of only oxygen gas into the reactive process zone 60 and the case of introduction of a mixture of oxygen gas and argon gas into the reaction process zone 60. In FIG. 5, the horizontal axis represents power to be applied from the RF power supply 69, and the vertical axis represents the emission intensity ratio. The emission intensity ratio is obtained by measuring the emission intensity of excited oxygen radicals and oxygen ions contained in a plasma by optical emission spectroscopy. As seen from FIG. 5, the density of excited oxygen radicals is higher in the case of introducing a mixture of oxygen gas and argon gas (i.e., the case of introducing oxygen gas at 110 sccm and argon gas at 40 sccm, namely, the case of introducing argon gas at the flow rate of approximately 27% to the total of the flow rate of oxygen gas and that of argon gas) into the reaction process zone 60 than in the case of introducing only oxygen gas at 150 sccm into the reaction process zone 60. The flow rate unit "sccm" represents flow rate per minute at 0°C and 1 atm, and is equal to cm³/min.

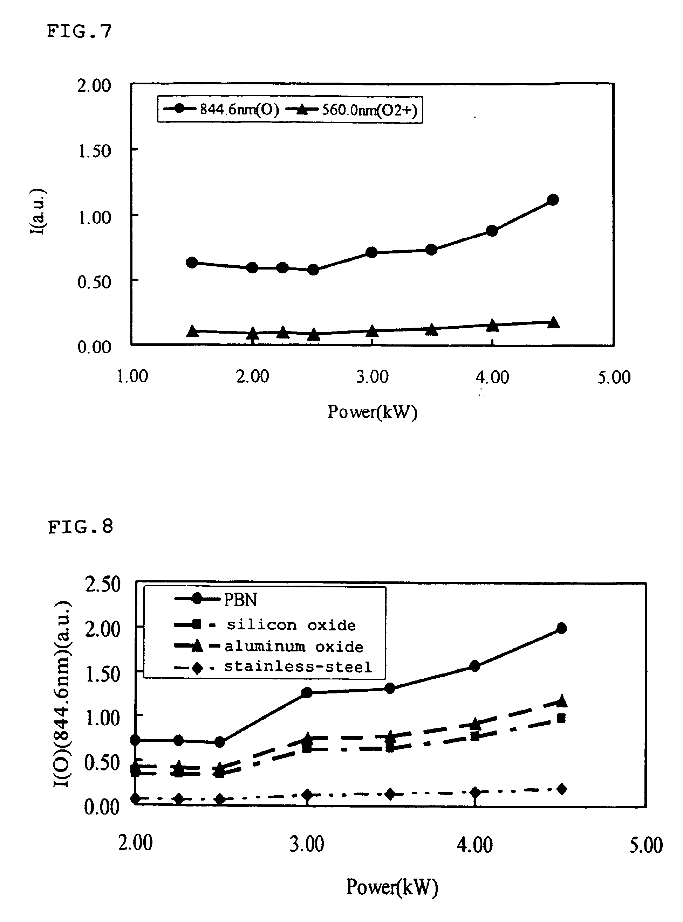

FIG. 6 shows the results of measuring the emission intensity of excited oxygen radicals and oxygen ions contained in a plasma by optical emission spectroscopy in the case of introducing a mixture of oxygen gas and argon gas (i.e., oxygen gas at 110 sccm and argon gas at 40 sccm) into the reaction process zone 60. FIG. 7 shows an example of comparison with the results of FIG. 6, and the results of measuring the emission intensity of excited oxygen radicals and oxygen ions contained in a plasma by optical emission spectroscopy in the case of introducing oxygen gas (at 150 sccm) into the reaction process zone 60, without introducing argon gas.

In FIG. 6 and FIG. 7, the horizontal axis represents power to be applied from the RF power supply 69, and the vertical axis represents the emission intensity ratio. The comparison of the results of FIG. 6 and FIG. 7 reveals that the emission intensity of oxygen radicals is strong and the density of oxygen radicals is high when introducing a mixture of oxygen gas and argon gas, compared with the case of introducing oxygen gas, without introducing argon gas.

Furthermore, in the present embodiment, as described above, since an insulator is deposited on portions of the partition 16 or the inner wall surface of the vacuum container 11 that faces the reaction process zone 60, the density of oxygen radicals in a plasma contained in the reaction process zone 60 can be kept high.

FIG. 8 shows the results of measuring the emission intensity of excited oxygen radicals contained in a plasma by optical emission spectroscopy in the case of changing compositions of the protection layer P deposited on the portions of the partition 16 or the inner wall surface of the vacuum container 11 that faces the reaction process zone 60. In FIG. 8 the horizontal axis represents power to be applied from the RF power supply 69, and the vertical axis represents the emission intensity ratio.

As shown in FIG. 8, it can be seen that the emission intensity of oxygen radicals is strong and the density of oxygen radicals is high, in the case of coating the partition 16 with the protection layer P formed of pyrolytic boron nitride (PBN), aluminum oxide (Al₂O₃) or silicon oxide (SiO₂), compared with the case of not providing the protection layer P (results of experiments marked as "stainless steel" in FIG. 8). In particular, it can be seen that the emission intensity of oxygen radicals is strong when the partition 16 is coated with the protection layer P formed of pyrolytic boron nitride (PBN).

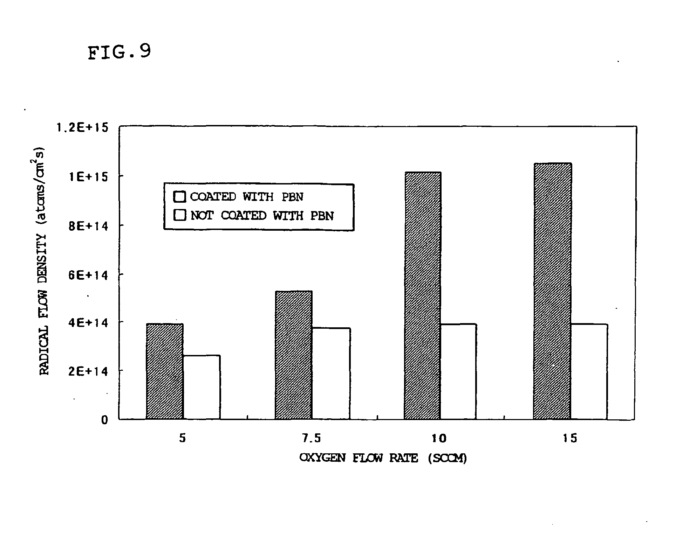

FIG. 9 is a graph showing the flow density of oxygen radicals in a plasma generated in the reaction process zone 60 and shows an example of comparative test results between the case where pyrolytic boron nitride (PBN) coating is applied to the partition 16 and to the vacuum container 11 and the case where PBN coating is not applied. In the present example test, in the case where pyrolytic boron nitride coating is applied to the partition 16 and to the vacuum container 11, pyrolytic boron nitride covers the surface of the partition 16 that faces the reactive process zone 60 and the inner surface of the vacuum container 11 that is surrounded by the partition 16 and faces the reaction process zone 60.

In FIG. 9, the horizontal axis represents the flow rate of oxygen gas being introduced into the reaction process zone 60, and the vertical axis represents the flow density of oxygen radicals in a plasma generated in the reaction process zone 60. In FIG. 9, the flow density of oxygen radicals represented along the vertical axis is the absolute flow density. The absolute flow density is obtained from the degree of oxidation of a thin film of silver. Specifically, a substrate on which a thin film of silver is formed is held on the substrate holder 13; a change in the weight of the thin film is obtained by measuring the weight before and after the thin film is subjected to plasma processing in the reaction process zone 60; the degree of oxidation of silver is obtained from the obtained change in the weight of the thin film; and the absolute flow density is calculated from the obtained degree of oxidation. As is apparent from FIG. 9, the flow density of oxygen radicals is high in the case where pyrolytic boron nitride coating is applied to the partition 16 and to the vacuum container 11.

The above description has discussed the case of forming a thin film of silicon oxide having a desired composition (SiOₓ (x ≤ 2)). However, through repeated sputtering by use of a plurality of film deposition process zones instead of a single film deposition process zone, thin films of different compositions can be formed in layers to thereby form a multilayered thin film. For example, as described previously, the film deposition process zone 40 is provided in the sputtering apparatus 1, and niobium (Nb) is used as the targets 49a and 49b. By a method similar to that for forming a thin film of silicon oxide, niobium oxide having a desired composition (NbO_{y} (y < 2.5)) is formed on a thin film of silicon oxide. By cyclically repeating the process of sputtering in the film deposition process zone 20, oxidation through plasma processing in the reaction process zone 60, sputtering in the film deposition process zone 40, and oxidation through plasma processing in the reaction process zone 60, there can be formed a thin film consisting of thin films of silicon oxide having a desired composition (SiOₓ (x ≤ 2)) and thin films of niobium oxide having a desired composition (NbO_{y} (y ≤ 2.5)) that are arranged in alternating layers.

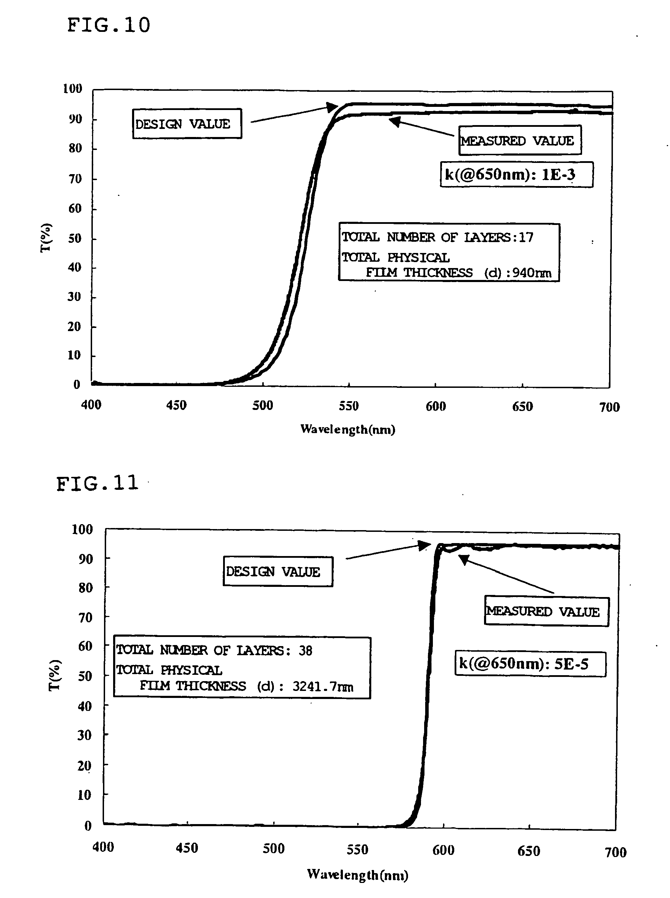

Particularly, according to the present embodiment, use of the plasma generator 61 in the sputtering apparatus 1 imparts high density, good quality, and high functional performance to a deposited thin film. The effect of the plasma generator 61 is apparent from FIGS. 10 and 11.

FIGS. 10 and 11 are graphs showing the transmittance of a multilayered thin film of silicon oxide (SiO₂) and niobium oxide (Nb₂O₅). FIG. 10 shows the test results in the case where a multilayered thin film of niobium oxide and silicon oxide is formed by use of the conventional plasma generator 161 of FIG. 12 in place of the plasma generator 61 of the sputtering apparatus 1. FIG. 11 shows the test results in the case where a multilayered thin film of niobium oxide and silicon oxide is formed by use of the plasma generator 61 of the present embodiment. In FIGS. 10 and 11, the horizontal axis represents measuring wavelength, and the vertical axis represents transmittance.

In the case of using the conventional plasma generator 161, voltage having a power of 5.5 kW was applied from the RF power supply 169, and SiO₂ and Nb₂O₅ were deposited at a rate of 0.3 nm/s and 0.2 nm/s, respectively. The SiO₂ layer and the Nb₂O₅ layer were alternately deposited 17 times in total, thereby forming a thin film having a total physical film thickness of 940 nm. The formed thin film exhibited an attenuation coefficient k of 100 x 10⁻⁵ as measured at a measuring wavelength of 650 nm (FIG. 10).

In the case of the sputtering apparatus 1 of the present embodiment, which employs the plasma generator 61, voltage having a power of 4.0 kW was applied from the RF power supply 69, and SiO₂ and Nb₂O₅ were deposited at a rate of 0.5 nm/s and 0.4 nm/s, respectively. The SiO₂ layer and the Nb₂O₅ layer were alternately deposited 38 times in total, thereby forming a thin film having a total physical film thickness of 3242 nm. The formed thin film exhibited an attenuation coefficient k of 5 x 10⁻⁵ as measured at a measuring wavelength of 650 nm (FIG. 11).

As seen from the test results in the case of forming a multilayered thin film of silicon oxide and niobium oxide by use of the sputtering apparatus 1 of the present embodiment, which employs the plasma generator 61, plasma processing by use of the sputtering apparatus 1 of the present embodiment enables formation of a favorable thin film having a small value of attenuation coefficient (absorption coefficient).
The attenuation coefficient k, the optical constant (complex index of refraction) N, and the index of refraction n hold the relation "N = n + ik."

The above-described embodiment can be modified, for example, as described below in (a) to (i). Variants (a) to (i) may be combined as appropriate for modification of the embodiment.

(a) The above-described embodiment employs inductively-coupled-type (plate-type) plasma generating means, in which, as shown in FIGS. 1 to 3, the antennas 65a and 65b are fixed to the plate-like dielectric wall 63. However, the present invention can be applied to a thin film deposition apparatus that employs another-type plasma generating means. Specifically, even in the case of a thin film deposition apparatus using plasma generating means of a type other than the inductively-coupled-type (plate-type), by means of coating the portions of the inner wall surface of the vacuum container 11 that faces the reaction process zone 60 and the surface of the plasma converging wall with an insulator, as in the above-described embodiment, there can be suppressed vanishment of radicals or excited radicals contained in a plasma generated by the plasma generating means - such vanishment would result from reaction of radicals or excited radicals with the inner wall surface of the vacuum container and with the surface of the plasma converging wall. Examples of plasma generating means of a type other than the inductively-coupled-type (plate-type) include parallel-plate-type (diode-discharge-type) plasma generating means, ECR (Electron Cyclotron Resonance)-type plasma generating means, magnetron-type plasma generating means, helicon-wave-type plasma generating means, and inductively-coupled-type (cylindrical-type) plasma generating means.

(b) The above embodiment is described while mentioning a sputtering apparatus as a thin film deposition apparatus. However, the present invention can be applied to thin film deposition apparatus of other types. Examples of such thin film deposition apparatus include an etching apparatus that performs etching by use of a plasma and a CVD apparatus that performs CVD by use of a plasma. The present invention can also be applied to a surface treatment apparatus that treats plastic surface by use of a plasma.

(c) The above embodiment is described while mentioning a carousel-type sputtering apparatus. However, the present invention is not limited thereto. The present invention can be applied to sputtering apparatus of other types in which substrates are transported while facing a region where a plasma is generated.

(d) According to the above-described embodiment, the protection layer P of an insulator is formed on the surface of the partition 16 that faces the reaction process zone 60 and on the inner wall surface of the vacuum container 11 that faces the reaction process zone 60. However, the protection layer P of an insulator may be formed on other portions. For example, an insulator may cover portions of the partition 16 other than the surface of the partition 16 that faces the reaction process zone 60. This can avoid a reduction in radicals, which would otherwise result from reaction of radicals with the partition 16, to the greatest possible extent. Also, an insulator may cover a portion of the inner wall surface of the vacuum container 11 other than that facing the reaction process zone 60; for example, the entire inner wall surface may be coated with an insulator. This can avoid a reduction in radicals, which would otherwise result from reaction of radicals with the inner wall surface of the vacuum container 11, to the greatest possible extent. The partition 12 may be coated with an insulator.

(e) In the above-described embodiment, while the antennas 65a and 65b are held between the dielectric wall 63 and the fixing plates 68a and 68b, the fixing plates 68a and 68b are fixed to the cover 11b by use of the bolts 68c and 68d, thereby fixing the antennas 65a and 65b. However, other fixing methods may be employed so long as the antennas 65a and 65b can be fixed while the distance D therebetween is adjusted as appropriate. For example, the following fixing method may be employed. The antenna 65a is fixed beforehand to the fixing plate 68a, and the antenna 65b is fixed beforehand to the fixing plate 68b. Elongated holes are provided beforehand in the cover 11b in order to allow the bolts 68c and 68d to be slidable in the vertical direction. The fixing plates 68a and 68b are slid in the vertical direction so as to adjust the distance D, and then the bolts 68c and 68d are fastened while the desired distance D is established. Thus, the fixing plates 68a and 68b are fixedly positioned in the vertical direction in relation to the cover 11b.

(f) The above embodiment is described while mentioning copper as material for forming the body member 65a₁ of the antenna 65a, and silver as material for forming the coating layer 65a₂. However, a combination of other materials may be employed so long as a material that is inexpensive, easily worked, and low in electric resistance is used to form the body member 65a₁, and a material lower in electric resistance than the body member 65a₁ is used to form the coating layer 65a₂, in which current concentrates. For example, the body member 65a₁ is formed of aluminum or an aluminum-copper alloy, whereas the coating layer 65a₂ is formed of copper or gold. The body member 65b₁ and the coating layer 65b2 of the antenna 65b may be modified similarly. Also, different materials may be used to form the antenna 65a and the antenna 65b.

(g) The above embodiment is described while mentioning oxygen as a reactive gas to be introduced into the reaction process zone 60. However, for example, an oxidizing gas, such as ozone or dinitrogen monoxide (N₂O), a nitriding gas, such as nitrogen, a carbonizing gas, such as methane, or a fluorinating gas, such as fluorine or carbon tetrafluoride (CF₄), may be introduced into the reaction process zone 60, whereby the present invention can be applied to plasma processing other than that for oxidation treatment.

(h) The above embodiment is described while mentioning silicon as material for the targets 29a and 29b, and niobium as material for the targets 49a and 49b. However, the present invention is not limited thereto, but their oxides may be used. Examples of other usable metals include aluminum (Al), titanium (Ti), zirconium (Zr), tin (Sn), chromium (Cr), tantalum (Ta), tellurium (Te), iron (Fe), magnesium (Mg), hafnium (Hf), nickel-chromium (Ni-Cr), and indium-tin (In-Sn). Compounds of these metals, such as Al₂O₃, TiO₂, ZrO₂, Ta₂O₅, and HfO₂, can also be used. Of course, the same material may be used to form the targets 29a, 29b, 49a, and 49b.

When these targets are used, the following films, for example, can be formed by plasma processing in the reaction process zone 60: an optical or insulating film of Al₂O₃, TiO₂, ZrO₂, Ta₂O₅, SiO₂, Nb₂O₅, HfO₂, or MgF₂, a conductive film of ITO, a magnetic film of Fe₂O₃, and an ultra-hard film of TiN, CrN, or TiC. Insulating metal compounds, such as TiO₂, ZrO₂, SiO₂, Nb₂O₅, and Ta₂O₅, exhibit a considerably low sputtering rate with resultant poor productivity as compared with metals (Ti, Zr, and Si). Therefore, plasma processing by use of the thin film deposition apparatus of the present invention is effective for forming thin films of such metal compounds.

(i) In the above-described embodiment, the targets 29a and 29b are of the same material, and the targets 49a and 49b are of the same material. However, the targets 29a and 29b or the targets 49a and 49b may be of different materials. As mentioned previously, when targets of the same metal are used, an incomplete reaction product of a single metal is formed on a substrate by sputtering; and when targets of different metals are used, an incomplete reaction product of an alloy is formed on a substrate.

### INDUSTRIAL APPLICABILITY

As described above, in the thin film deposition apparatus and the thin film deposition method of the present invention, plasma processing can be performed efficiently over a wide range.

## Claims

1. A thin film deposition apparatus, comprising
a vacuum container (11) for maintaining a vacuum therein,
gas introduction means (75, 76) for introducing a reactive gas into the vacuum container (11),
plasma generating means (61) for generating a plasma of said reactive gas within said vacuum container (11), and
an insulator (P) is deposited on the inner wall surface of said vacuum container (11); said gas introduction means (75, 76) introduces the reactive gas and an inert gas into a region where the plasma is generated by said plasma generating means (61),
wherein the insulator (P) is coated on the inner wall surface of the vacuum container (11) that faces a region where the plasma is generated by the plasma generating means (61), and
**characterized in that**
the apparatus further comprising a plasma converging wall (16) which is provided on the inner wall surface of the vacuum container (11) to project from the inner wall; surface and which faces a region where the plasma is generated by the plasma generating means (61),
wherein the inner wall surface coated with the insulator (P) is a surface of the plasma converging wall (16).

2. A thin film deposition apparatus as described in claim 1, wherein said inert gas is selected from a group consisting of argon gas, helium gas, neon gas, krypton gas, and xenon gas.

3. A thin film deposition apparatus as described in one of claim 1 or claim 2, wherein said insulator (P) is selected from a group consisting of pyrolytic boron nitride, aluminum oxide or silicon oxide.

4. A thin film deposition apparatus as described in one of claim 1 to claim 3, wherein said insulator (P) is deposited on the inner wall surface of the vacuum container (11) by evaporation method or spraying process.

5. A thin film deposition apparatus as described in one of claim 1 or claim 2, wherein said insulator (P) is pyrolytic boron nitride, and said insulator (P) is deposited on the plasma converging wall (16) or on the inner wall surface of the vacuum container (11) by a pyrolysis process that utilizes chemical vapor deposition.

## Patentansprüche

1. Dünnschicht-Abscheidevorrichtung, die umfasst:
einen Vakuumbehälter (11), in dem ein Vakuum aufrechterhalten wird,
eine Gas-Einleiteinrichtung (75, 76) zum Einleiten eines reaktiven Gases in den Vakuumbehälter (11),
eine Plasmaerzeugungseinrichtung (61) zum Erzeugen eines Plasmas aus dem reaktiven Gas im Inneren des Vakuumbehälters (11), und
wobei ein Isolator (P) an der Innenwandfläche des Vakuumbehälters (11) abgeschieden ist;
die Gas-Einleiteinrichtung (75, 76) das reaktive Gas und ein inertes Gas in einen Bereich einleitet, in dem durch die Plasmaerzeugungseinrichtung (61) das Plasma erzeugt wird,
wobei der Isolator (P) an der Innenwandfläche des Vakuumbehälters (11) aufgetragen ist, die einem Bereich zugewandt ist, in dem durch die Plasmaerzeugungseinrichtung (61) das Plasma erzeugt wird, und
**dadurch gekennzeichnet, dass**
die Vorrichtung des Weiteren eine Plasma-Sammelwand (16) umfasst, die an der Innenwandfläche des Vakuumbehälters (11) vorhanden ist, von der Innenwandfläche vorsteht und einem Bereich zugewandt ist, in dem durch die Plasmaerzeugungseinrichtung (61) das Plasma erzeugt wird,
wobei die mit dem Isolator (P) beschichtete Innenwandfläche eine Fläche der Plasma-Sammelwand (16) ist.

2. Dünnschicht-Abscheidevorrichtung nach Anspruch 1, wobei das inerte Gas aus einer Gruppe ausgewählt wird, die aus Argon-Gas, Helium-Gas, Neon-Gas, Krypton-Gas und Xenon-Gas besteht.

3. Dünnschicht-Abscheidevorrichtung nach Anspruch oder Anspruch 2, wobei der Isolator (P) aus einer Gruppe ausgewählt wird, die aus pyrolytischem Bornitrid, Aluminiumoxid oder Siliziumoxid besteht.

4. Dünnschicht-Abscheidevorrichtung nach einem der Ansprüche 1 bis 3, wobei der Isolator (P) an der Innwandfläche des Vakuumbehälters (11) mit einem Aufdampfverfahren oder einem Spritzprozess abgeschieden wird.

5. Dünnschicht-Abscheidebevorrichtung nach Anspruch 1 oder Anspruch 2, wobei der Isolator (P) pyrolytisches Bornitrid ist und der Isolator (P) mit einem Pyrolyseprozess, bei dem chemisches Aufdampfen zum Einsatz kommt, an der Plasma-Sammelwand (16) oder an der Innenwandfläche des Vakuumbehälters (11) abgeschieden wird.

## Revendications

1. Appareil de dépôt de film mince, comprenant :
un récipient de maintien de vide (11) destiné à maintenir un certain vide en lui,
un moyen d'introduction de gaz (75, 76) destiné à introduire un gaz réactif dans le récipient de maintien de vide (11),
un moyen de génération de plasma (61) destiné à générer un plasma dudit gaz réactif à l'intérieur dudit récipient de maintien de vide (11), et
un isolant (P) qui est déposé sur la surface de la paroi interne dudit récipient de maintien de vide (11),
ledit moyen d'introduction de gaz (75, 76) introduit le gaz réactif et un gaz inerte dans une zone où le plasma est généré par ledit moyen de génération de plasma (61),
dans lequel l'isolant (P) est déposé sur la surface de la paroi interne du récipient de maintien de vide (11) qui fait face à une zone où est généré le plasma par le moyen de génération de plasma (61), et
**caractérisé en ce que**
l'appareil comprend en outre une paroi de convergence du plasma (16) qui est prévue sur la surface de la paroi interne du récipient de maintien de vide (11) afin de dépasser de la surface de paroi interne et qui fait face à une zone où est généré le plasma par le moyen de génération de plasma (61),
dans lequel la surface de la paroi interne, revêtue par l'isolant (P) est une surface de la paroi de convergence de plasma (16).

2. Appareil de dépôt de film mince selon la revendication 1, dans lequel ledit gaz inerte est sélectionné à partir d'un groupe constitué d'argon, d'hélium, de néon, de krypton et de xénon.

3. Appareil de dépôt de film mince selon la revendication 1 ou la revendication 2, dans lequel ledit isolant (P) est sélectionné à partir d'un groupe constitué de nitrure de bore pyrolytique, d'oxyde d'aluminium ou d'oxyde de silicium.

4. Appareil de dépôt de film mince selon l'une de la revendication 1 à la revendication 3, dans lequel ledit isolant (P) est déposé sur la surface de la paroi interne du récipient de maintien de vide (11) grâce à un procédé d'évaporation ou un processus de pulvérisation.

5. Appareil de dépôt de film mince selon l'une de la revendication 1 ou de la revendication 2, dans lequel ledit isolant (P) et du nitrure de bore pyrolytique et ledit isolant (P) est déposé sur la paroi de convergence de plasma (16) ou sur la surface de la paroi interne du récipient de maintien de vide (11) grâce à un processus de pyrolyse qui utilise un dépôt chimique en phase vapeur.
